# EUROPEAN PATENT SPECIFICATION

(11) **EP 1 811 824 B1**
(45) Date of publication and mention of the grant of the patent: **13.01.2010**
(21) Application number: 06823039.0
(22) Date of filing: 07.11.2006
(51) Int. Cl.: H05K 3/46, H01L 23/12

(54) **MULTILAYER PRINTED WIRING BOARD AND PROCESS FOR PRODUCING THE SAME**
MEHRSCHICHTIGE LEITERPLATTE UND HERSTELLUNGSVERFAHREN DAFÜR
CARTE A CIRCUIT IMPRIME MULTI-COUCHE ET SON PROCEDE DE PRODUCTION

(30) Priority: 07.11.2005 JP 2005321954
(43) Date of publication of application: 25.07.2007
(73) Proprietor: Panasonic Corporation, Kadoma-shi Osaka 571-8501 (JP)
(72) Inventor: NAKAMURA, Tadashi, Matsushita Electric Industrial Co., Ltd., Chuo-ku, Osaka-shi, Osaka 540-6319 (JP); ECHIGO, Fumio, Matsushita Electric Industrial Co., Ltd., Chuo-ku, Osaka-shi, Osaka 540-6319 (JP); HIRAI, Shogo, Matsushita Electric Industrial Co., Ltd., Chuo-ku, Osaka-shi, Osaka 540-6319 (JP); SUGAWA, Toshio, Matsushita Electric Industrial Co., Ltd., Chuo-ku, Osaka-shi, Osaka 540-6319 (JP)
(74) Representative: Grünecker, Kinkeldey, Stockmair & Schwanhäusser Anwaltssozietät
(86) International application number: PCT/JP2006/322126
(87) International publication number: WO 2007/052799

(56) References cited:
- EP-A- 1 283 662
- JP-A- 11 112 118
- JP-A- 2004 072 125
- JP-A- 2005 129 884
- US-A- 5 640 761
- US-A1- 2002 131 229
- US-A1- 2004 031 147
- US-A1- 2004 052 945

## Description

### TECHNICAL FIELD

The present invention relates to a multilayer printed wiring board used in a portable telephone, a very small portable terminal, and the like, or a multilayer printed wiring board used as an interposer and the like when a semiconductor chip is bare-chip mounted, and a method for manufacturing the same.

### BACKGROUND ART

Conventionally, as this type of multilayer printed wiring board (hereinafter, just referred to as a multilayer board), a multilayer board having an IVH (inner via hole) in an arbitrary position is disclosed in, for example, patent document 1.

The market has demanded further thinning of a multilayer board. Hereinafter, a multilayer board using a film as a means for thinning a multilayer board is described.

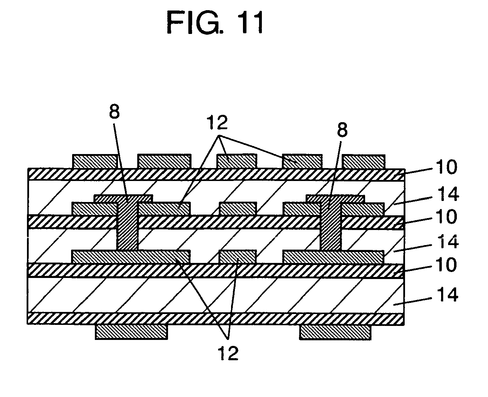

Fig. 11 is a sectional view showing an example of a conventional multilayer printed wiring board, which is an example of a multilayer wiring board in which films are laminated with an adhesive. As shown in Fig. 11, on film 10, a predetermined pattern of wirings 12 is formed. A plurality of films 10 are adhesively bonded together with wirings 12 by using adhesive 14. Furthermore, by forming IVHs 8 in necessary parts, wirings 12 formed on different layers are coupled to each other.

However, in a conventional configuration, since adhesive 14 is used for coupling films 10 to each other, there is a limitation in thinning.

For example, in a configuration shown in Fig. 11, since films 10 having wiring 12 on one surface thereof are laminated, when a four-layer multilayer board is formed, the thickness for seven layers including three layers of adhesive 14 and four layers of films 10 is needed. Therefore, thinning has been difficult.

On the other hand, as an application of the configuration shown in Fig. 11, it is thought that two films 10 having wiring 12 on both surfaces thereof are prepared and the two films are attached to each other so as to form a four-layer multilayer board. In this case, films 10 having wiring 12 on both surface thereof are attached to each other with adhesive 14. However, when they are attached to each other, adhesive 14 is softened and fluidized, so that wirings 12 facing each other may be short-circuited.
[Patent document 1] Japanese Patent Unexamined Publication No. 2002-353619

Other multilayer boards are known from documents US-A-5 640 761 and US 2002/131229 A1.

### SUMMARY OF THE INVENTION

A multilayer printed wiring board of the present invention is defined in claims 1 and 2.

Furthermore, a method of manufacturing a multilayer printed wiring board of the present invention is defined in claim 7.

### BRIEF DESCRIPTION OF THE DRAWINGS

Fig. 1 is a sectional view showing a multilayer board in accordance with a first exemplary embodiment.
Fig. 2A is a sectional view to illustrate a method of manufacturing a four-layer printed wiring board in accordance with a second exemplary embodiment.
Fig. 2B is a sectional view to illustrate a method of manufacturing a four-layer printed wiring board in accordance with the second exemplary embodiment.
Fig. 2C is a sectional view to illustrate a method of manufacturing a four-layer printed wiring board in accordance with the second exemplary embodiment.
Fig. 3A is a sectional view to illustrate a method of manufacturing a four-layer printed wiring board in accordance with the second exemplary embodiment.
Fig. 3B is a sectional view to illustrate a method of manufacturing a four-layer printed wiring board in accordance with the second exemplary embodiment.
Fig. 3C is a sectional view to illustrate a method of manufacturing a four-layer printed wiring board in accordance with the second exemplary embodiment.
Fig. 4 is a sectional view showing a multilayer printed wiring board in accordance with a third exemplary embodiment.
Fig. 5A is a sectional view to illustrate a method of manufacturing a multilayer printed wiring board in accordance with a fourth exemplary embodiment.
Fig. 5B is a sectional view to illustrate a method of manufacturing a multilayer printed wiring board in accordance with the fourth exemplary embodiment.
Fig. 6 is a sectional view showing a multilayer printed wiring board in accordance with a fifth exemplary embodiment.
Fig. 7A is a sectional view to illustrate a method of manufacturing a multilayer printed wiring board in accordance with a sixth exemplary embodiment.
Fig. 7B is a sectional view to illustrate a method of manufacturing a multilayer printed wiring board in accordance with the sixth exemplary embodiment.
Fig. 8 is a sectional view showing an example of a method of manufacturing a multilayer printed wiring board having a fine pattern on a surface layer in accordance with a seventh exemplary embodiment.
Fig. 9A is a sectional view showing an example of a method of manufacturing a multilayer printed wiring board having a fine pattern on a surface layer in accordance with the seventh exemplary embodiment.
Fig. 9B is a sectional view showing an example of a method of manufacturing a multilayer printed wiring board having a fine pattern on a surface layer in accordance with the seventh exemplary embodiment.
Fig. 10A is a sectional view to illustrate an example of the method of manufacturing the multilayer printed wiring board having a fine pattern on the surface layer in accordance with the seventh exemplary embodiment.
Fig. 10B is a sectional view to illustrate an example of the method of manufacturing the multilayer printed wiring board having a fine pattern on the surface layer in accordance with the seventh exemplary embodiment.
Fig. 11 is a sectional view showing an example of a conventional multilayer printed wiring board.

### REFERENCE MARKS IN THE DRAWINGS

- 102, 102a, 102b, 102c: resin film
- 104a, 104b: first wiring
- 106a, 106b, 106c, 106d: second wiring
- 108: insulating resin
- 110: IVH (inner via hole)
- 112: interlayer coupling part
- 114a, 114b, 114c: double-sided board
- 116: paste coupling layer
- 118: retention film
- 120: provisionally hardened resin
- 122: film prepreg
- 124: through hole
- 126: conductive paste
- 128: multilayer board
- 130: interlayer insulating layer
- 132: inner electrode
- 134a, 134b: single-sided board
- 136: blind via
- 138: metal film

### DETAILED DESCRIPTION OF THE PREFERRED EMBODIMENTS

Hereinafter, exemplary embodiments of the present invention are described with reference to drawings.

### (FIRST EXEMPLARY EMBODIMENT)

Hereinafter, a multilayer board in accordance with a first exemplary embodiment of the present invention is described with reference to drawings.

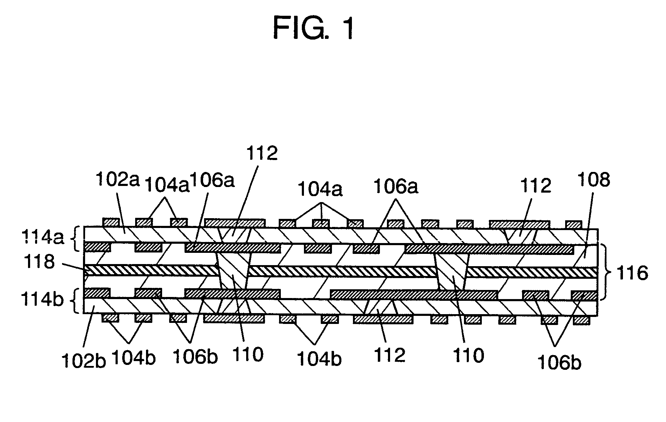

Fig. 1 is a sectional view showing a multilayer board in accordance with the first exemplary embodiment of the present invention. As shown in Fig. 1, the multilayer board includes resin films 102a and 102b, first wirings 104a and 104b, second wirings 106a and 106b, insulating resin 108, IVH 110, interlayer coupling part 112, double-sided boards 114a and 114b, paste coupling layer 116, and retention film 118.

As shown in Fig. 1, double-sided board 114a includes film 102a having first wiring 104a on one surface thereof and second wiring 106a on the other surface thereof. First wiring 104a and second wiring 106a are coupled to each other with interlayer coupling part 112. Similarly, double-sided board 114b includes film 102b having first wiring 104b on one surface thereof and second wiring 106b on the other surface thereof. First wiring 104b and second wiring 106b are coupled to each other with interlayer coupling part 112.

Herein, first wirings 104a and 104b correspond to wirings exposed on the surface of the printed wiring board of the first exemplary embodiment. On the other hand, second wirings 106a and 106b are embedded in insulating resin 108 in a state in which they are formed on the surface of double-sided boards 114a and 114b. Since second wirings 106a and 106b are embedded in insulating resin 108, the thicknesses of wirings 106a and 106b are absorbed and do not easily appear as convex and concave portions on the surface of a sample. Furthermore, IVH 110 is an inner via hole (interlayer coupling). Second wiring 106a formed on the surface of resin film 102a and second wiring 106b formed on the surface of resin film 102b are electrically coupled by IVH 110. As shown in Fig. 1, IVH 110 penetrates insulating resin 108 and retention film 118, so that second wiring 106a and second wiring 106b, which face each other, are electrically coupled to each other. Furthermore, paste coupling layer 116 includes insulating resin 108 formed on both surfaces of retention film 118, and IVH 110 penetrating insulating resin 108 and retention film 118.

With reference to Fig. 1, the way of counting the number of wirings or insulating layers is described. When the number is counted from the upper part to the lower part in Fig. 1, a first insulating layer (corresponding to a surface layer) that is the first layer counted from the surface layer corresponds to film 102a; a second insulating layer that is the second layer counted from the surface layer corresponds to paste coupling layer 116; and a third insulating layer that is the third layer counted from the surface layer corresponds to film 102b, respectively.

Similarly, a first wiring (corresponding to a wiring on the surface layer) that is the first layer counted from the surface layer corresponds to first wiring 104a; a second wiring that is the second layer counted from the surface layer corresponds to second wiring 106a; a third wiring that is the third layer counted from the surface layer corresponds to second wiring 106b; and a fourth wiring that is the fourth layer counted from the surface layer corresponds to first wiring 104b. Fig. 1 shows a four-layer structure including four layers of electrodes and is symmetrical in the up and down direction. Therefore, there is no difference between counting from the upper part to the lower part and counting from the lower part to the upper part. However, in principle, in the first exemplary embodiment of the present invention, layers and wirings are counted from the upper part to the lower part.

Thus, as shown in Fig. 1, the second insulating layer formed in the second layer counted from the surface layer is paste coupling layer 116. An electrical connection penetrating paste coupling layer 116 corresponds to IVH 110. Second wiring 106a that is the second wiring formed in the second layer counted from the surface layer and second wiring 106b that is the third wiring formed in the third layer counted from the surface layer are embedded in insulating resin 108. With insulating resin 108 and retention film 118, short-circuit does not occur between second wirings 106a and 106b formed in parts without having IVH 110.

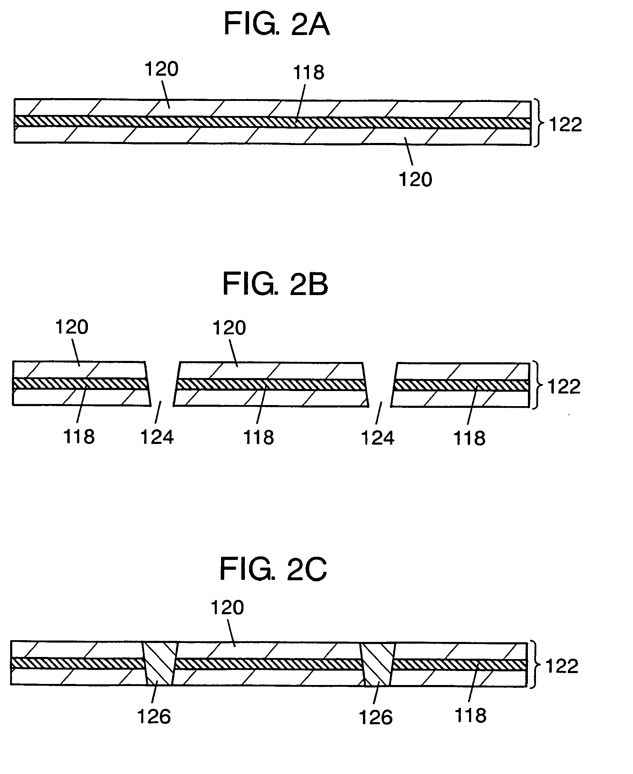

IVH 110 in the first exemplary embodiment is obtained by filling a conductive paste into a through hole formed in insulating resin 108. With reference to the below-mentioned Figs. 2A, 2B and 2C, through hole 124 and conductive paste 126 are described. Furthermore, IVH 110 is formed between double-sided boards 114a and 114b so as to couple second wirings 106a and 106b. IVH 110 can be formed in arbitrary positions of paste coupling layer 116. Thus, in the multilayer board in the first exemplary embodiment, the thicknesses of plurality of double-sided boards 114a and 114b using films 102a and 102b are absorbed by insulating resin 108 and at the same time, interlayer coupling is carried out by IVH 110.

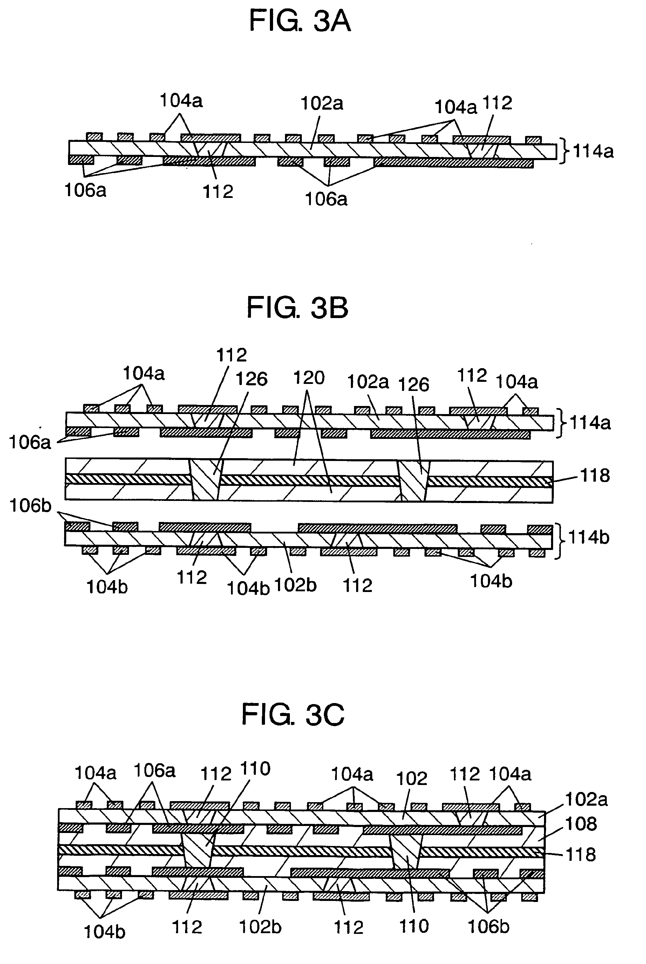

In the first exemplary embodiment, as members constituting paste coupling layer 116, a member obtained by forming a predetermined resin on both surfaces of retention film 118 to a predetermined thickness is used. Two double-sided boards 114a and 114b are attached and integrated to each other by using this member as described with reference to below-mentioned Figs. 2A to 3C. Thus, in the first exemplary embodiment, retention film 118 built in insulating resin 108 prevents short-circuit between second wirings 106a and 106b formed on double-sided boards 114a and 114b. Consequently, the total thickness of the multilayer board itself can be remarkably reduced. Note here that the detail of the resin is described with reference to Figs. 2A and 3C.

As mentioned above, an electrical connection penetrating the second insulating layer (corresponding to paste coupling layer 116 in Fig. 1) that is formed in the second layer counted from the surface layer is a conductive paste (corresponding to IVH in 110 in Fig. 1).

The second wiring that is formed in the second layer counted from the surface layer (in Fig. 1, the second wiring corresponds to second wiring 106a formed on double-sided board 114a when counted from the upper part, and second wiring 106b when counted from the lower part) and the third wiring that is formed in the third layer counted from the surface layer are embedded in paste coupling layer 116 and electrically coupled to each other. In Fig. 1, when counted from the upper part, the third wiring corresponds to second wiring 106b formed on double-sided board 114b. Similarly, when counted from the lower part, the third wiring corresponds to second wiring 106a formed on double-sided board 114a.

Thus, in the first exemplary embodiment, when a four-layer board (the four-layer herein means that four layers of wirings are provided) is configured by using insulating resin 108, electrodes facing each other can be prevented from being short-circuited. Therefore, insulating resin 108 can be thinned. As a result, the thickness of the four-layer board can be reduced.

### (SECOND EXEMPLARY EMBODIMENT)

Hereinafter, a method of manufacturing a multilayer board in accordance with a second exemplary embodiment of the present invention is described. The second exemplary embodiment shows an example of a method of manufacturing a four-layer board and corresponds to, for example, a method of manufacturing a four-layer board described in the first exemplary embodiment. Figs. 2A, 2B and 2C and Figs. 3A, 3B and 3C are sectional views to illustrate a method of manufacturing a four-layer printed wiring board in accordance with the second exemplary embodiment.

As shown in Figs. 2A, 2B and 2C, the four layer printed wiring board in accordance with the second exemplary embodiment includes provisionally hardened resin 120, film prepreg 122, through hole 124 and conductive paste 126. Firstly, as shown in Fig. 2A, provisionally hardened resin 120 is formed to a predetermined film thickness on both surfaces of retention film 118 so as to prepare film prepreg 122. Then, as shown in Fig. 2B, provisionally hardened resin 120 and protective film 118, which constitute film prepreg 122, are provided with through holes 124. Through hole 124 can be formed by using a mold, drill, laser, and the like. Next, as shown in Fig. 2C, conductive paste 126 is filled into through hole 124. For example, by using film prepreg 122 and a protective film (not shown) formed thereon as a mask, conductive paste 126 is rubbed by using a squeegee and the like. Alternatively, conductive paste 126 is filled. Thus, conductive paste 126 can be filled into only through hole 124 formed in film prepreg 122 in a self-alignment manner.

It is desirable that a protective film (not shown in Figs. 2A and 2B) is attached on the surface of provisionally hardened resin 120 in advance. When the protective film is used, through hole 124 shown in, for example, Fig. 2B can be formed easily. Moreover, when this protective film is used as a kind of mask, conductive paste 126 is filled into through hole 124 easily. Then, after conductive paste 126 is filled, the protective film (not shown) is peeled off. Thus, film prepreg 122 is processed in the state shown in Fig. 2C (hereinafter, the thus processed prepreg 122 is referred to as Fig. 2C product).

As retention film 118, it is desirable to use a heat resistant film such as a polyimide film, a polyamide film, and an aramid film. The use of a highly heat-resistant resin film can improve the heat resistance of the produced multilayer board. Furthermore, it is desirable to select the thickness of retention film 118 of not more than 100 µm, particularly not less than 5 µm and not more than 50 µm, desirably not more than 30 µm, and further not more than 25 µm if possible. By using such a very thin heat resistant film, the total film thickness of the produced multilayer board can be reduced. On both surfaces of retention film 118 including such a heat resistant film, hardened resin is applied to a predetermined thickness by using an applier and provisionally hardened, thereby it can be heated and fully hardened together with double-sided boards as shown in the below mentioned Figs. 3B and 3C. Note here that provisional hardening means a slightly hardened state and a state having flexibility. Furthermore, resin in a provisionally hardened state is in a state that is softened when it is re-heated. By adjusting the re-heating state, resin can be fully hardened.

Fig. 3A is a sectional view showing double-sided board 114a. In Fig. 3A, double-sided board 114a includes first wiring 104a formed on one surface of film 102a and second wiring 106a formed on the other surface. Interlayer coupling part 112 penetrating resin film 102a couples between the layer of first wiring 104a and the layer of second wiring 106a.

Herein, as a material of resin films 102a and 102b, it is desirable to use heat resistant film such as a polyimide film, a polyamide film and an aramid film similar to retention film 118. By using such a highly heat-resistant resin film, thermal influence in, for example, soldering can be suppressed. Furthermore, it is desirable to select the thickness of such a heat resistant film of not more than 100 µm, particularly not less than 5 µm and not more than 50 µm, desirably not more than 30 µm, and further not more than 25 µm if possible. In particular, retention film 118 can be about 5 micron because the both surfaces of retention film 118 are coated with provisionally hardened resin 120 and a protective film. By using such a very thin heat resistant film, the total thickness of the obtained multilayer board can be reduced. As double-sided board 114a, it is possible to select a board material obtained by forming copper foil on both surfaces of a very thin heat resistant film without using an adhesive. For example, it is possible to select the below-mentioned CCL (copper clad laminate). Furthermore, in the case where a very thin heat resistant film is used as retention film 118, by subjecting the surface thereof to surface modification such as surface roughing treatment and plasma treatment, the adhesiveness with respect to provisionally hardened resin 120 formed thereon can be improved. Similarly, resin films 102a and 102b can be thinned to, for example, the thickness of 10 microns or 5 microns although they have a copper foil on at least one surface.

Fig. 3B shows a state in which double-sided boards 114a and 114b are aligned with respect to both surfaces of Fig. 2C product. In Fig. 3B, second wiring 106a of double-sided board 114a and second wiring 106b of double-sided board 114b face the side of Fig. 2C product. Then, second wirings 106a and 106b and conductive paste 126 are aligned. In a state in which they are aligned, they are heated and pressed in a vacuum press (vacuum press is not shown). Then, after vacuum pressing is completed, a pressed sample is taken out. Fig. 3C is a sectional view showing a sample that has already undergone vacuum pressing.

A sample or a predetermined laminated body corresponding to Fig. 3C is heated and hardened in a vacuum press at a predetermined temperature profile. Then, provisionally hardened resin 120 is softened and hardened so as to be changed into insulating resin 108. When provisionally hardened resin 120 is softened, wirings 106a and 106b formed on double-sided boards 114a and 114b are embedded in the softened provisionally hardened resin, so that the thickness of the wiring is absorbed. Then, provisionally hardened resin 120 is hardened in a state in which the wiring thickness is absorbed, and turned to be insulating resin 108 so as to strongly fix double-sided boards 114a and 114b. Furthermore, at this time, conductive paste 126 embedded in provisionally hardened resin 120 and retention film 118 is simultaneously hardened and changed into IVH 110. Thus, four-layer board having IVH 110 is formed. Then, the thickness of second wirings 106a and 106b or concavity and convexity due to the thickness are reduced or flattened. Furthermore, at the time of vacuum pressing, even if second wirings 106a and 106b are strongly pressed to each other, a short-circuit between them does not occur because retention film 118 is provided.

Furthermore, a method of manufacturing a four-layer board in accordance with the second exemplary embodiment is described in detail. Firstly, as retention film 118, for example, a commercially available polyimide film having a thickness of about 10 micron is selected. On both surfaces of this film, epoxy resin is thinly coated by using a coater (coating device). After the coater is used, the resin is provisionally hardened by using an installed dryer. Then, in order to protect the surface of provisionally hardened resin 120, a protective film is attached to the surface of provisionally hardened resin 120. Thus, a sample in a state of Fig. 2A is produced. In Fig. 2A, the protective film on provisionally hardened resin 120 is not shown.

Next, as shown in Fig. 2B, through holes 124 are formed in predetermined positions in a state in which a protective film (not shown in Fig. 2B) is formed on a prepreg. Next, on the protective film, a predetermined amount of conductive paste 126 is added and filled into through hole 124 in such a manner as to print conductive paste 126 by using a squeegee (rubber spatula). Thereafter, when a protective film is peeled, as shown in Fig. 2C, film prepreg 122 is processed.

Next, as shown in Fig. 3A, double-sided board 114a is prepared. As double-sided board 114a, a double-sided copper-clad film is used. Specifically, a film obtained by attaching copper foil on both surfaces of a 10 µm-thick polyimide film without using any adhesives is used. Specifically, it is desirable to use a commercially available CCL. Next, a copper foil part of the double-sided copper-clad film is processed into a predetermined pattern so as to form double-sided board 114a shown in Fig. 3A. It is desirable to select a CCL without using any adhesives. By selecting such a double-sided copper-clad film without using any adhesives, for example, by selecting a film using a thin film method for a base material and the like, it is possible to prevent the occurrence of a problem caused by an adhesive.

As shown in Fig. 3B, on both surfaces of Fig. 2C product, double-sided boards 114a and 114b are aligned by using a predetermined jig (not shown). Thereafter, they are pressed in a vacuum press for a predetermined time at a predetermined temperature, so that they are integrated with each other. At this time, it is desirable that they are heated and pressed if necessary. Furthermore, this pressing condition is made to be a condition in which provisionally hardened resin 120 is softened and then hardened. At the same time, with conductive paste 126, second wirings 106a and 106b that are formed at the side of film prepreg 122 of double-sided boards 114a and 114b are electrically coupled to each other.

Thus, a very thin multilayer board as shown in Fig. 3C is produced. Herein, the thicknesses of films 102a and 102b, retention film 118 and provisionally hardened resin 120 are reduced to, for example, 40 µm or 20 µm, and furthermore 10 µm. Consequently, a very thin multilayer board having a total thickness of about not more than 100 µm, or not more than 60 µm, furthermore not more than 30 µm can be produced.

As mentioned above, it is possible to produce a four-layer printed wiring board including paste coupling layer 116, in which an electrical connection penetrating a second insulating layer (the second insulating layer corresponds to paste coupling layer 116 in Fig. 3C) that is the second layer counted from the surface layer of the four-layer printed wiring board that is conductive paste 126. A second wiring (corresponding to second wiring 106a in Fig. 3C) provided in the second layer counted from the surface layer and a third wiring (corresponding to third wiring 106b in Fig. 3C) provided in the third layer counted from the surface layer are embedded in paste coupling layer 116.

As mentioned above, in the second exemplary embodiment, both "second wiring (corresponding to second wiring 106a in Fig. 3C) that is a second layer counted from the surface layer" and "third wiring (corresponding to third wiring 106b in Fig. 3C) that is a third layer counted from the surface layer" can be embedded in paste coupling layer 116. Therefore, even if the thickness of the board is thinned, the thickness of the wiring can be absorbed. The mounting property of chip components, semiconductor chip, and the like, can be improved so as to be applied for bare chip mounting and furthermore, an interposer for CPU mounting.

Furthermore, paste coupling layer 116 includes provisionally hardened resin 120 and conductive paste 126 that is filled into through hole 124 formed in provisionally hardened resin 120. Consequently, it is possible to freely design positions in which IVH 110 is formed, thus enabling a circuit board to have a small size and high performance.

### (THIRD EXEMPLARY EMBODIMENT)

Hereinafter, a multilayer board in accordance with a third exemplary embodiment of the present invention is described with reference to drawings. The third exemplary embodiment is different from the first exemplary embodiment in the number of films to be used for forming the multilayer structure. In the first exemplary embodiment, two films are used; and in the third exemplary embodiment, three films are used.

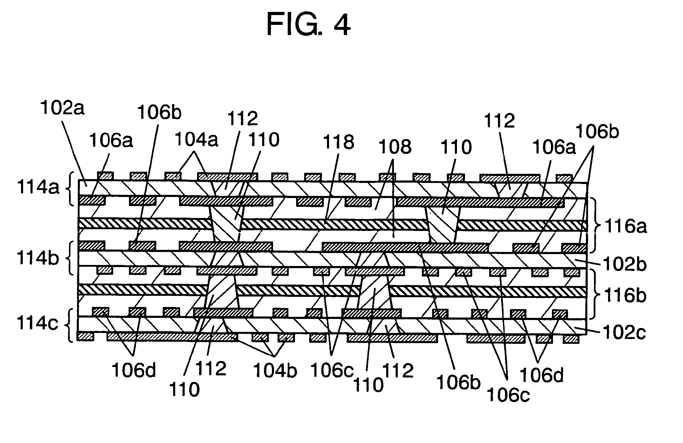

Fig. 4 is a sectional view showing a multilayer printed wiring board in accordance with the third exemplary embodiment. In Fig. 4, double-sided boards 114a, 114b, and 114c using a film are attached to each other by using two paste coupling layers 116a and 116b. Then, second wiring 106a formed on the surface of double-sided board 114a and second wiring 106b formed on the surface of double-sided board 114b are electrically coupled to each other via IVH 110. Similarly, second wiring 106d formed on double-sided board 114c and second wiring 106c formed on double-sided board 114b are electrically coupled to each other via IVH 110.

Thus, three double-sided boards 114a, 114b and 114c are integrated by using paste coupling layers 116a and 116b. Herein, the total number of layers for wiring is six layers, which can be calculated from: two layers of wiring × three sheets. Among the total six layers of wirings, the thickness of four layers of wirings can be absorbed by embedding them in paste coupling layers 116a and 116b. Thus, a multilayer board having reduced thickness and flattened surface can be produced. Herein, in the case shown in Fig. 4, the multilayer board is a six-layer board.

Paste coupling layers 116a and 116b include insulating resin 108 and IVH 110. Herein, IVH 110 is an inner via hole. In the case of this exemplary embodiment, IVHs 110 can be formed in arbitrary portions. As an insulating member constituting paste coupling layer 116, film prepreg 122 can be used. It is desirable to use hardened conductive paste 126 as a conductive member constituting IVH 110. Thus, in the multilayer board in accordance with the third exemplary embodiment, by filling the hardened conductive paste into through hole 124 formed in film prepreg 122 and laminating thereof, the multilayer board can be significantly thinned.

As mentioned above, it is possible to produce a multilayer board that is a printed wiring board including not less than five layers, in which an electrical connection between second insulating layers (insulating resin 108 in Fig. 4) formed in the second layer counted from at least one of the surface layers is IVH 110 that is a hardened product of conductive paste 126. This multilayer board has paste coupling layers 116a and 116b in which the second wiring provided in the second layer from the surface layer and the third wiring provided in the third layer counted from the surface layer are coupled to each other with paste coupling layer 116a. Similarly, in Fig. 4, second wiring 106c and second wiring 106d are embedded in paste coupling layer 116b. The second wiring corresponds to second wiring 106a formed on double-sided board 114a when counted from the upper part in Fig. 4. Furthermore, third wiring corresponds to second wiring 106b formed on double-sided board 114b when counted from the upper part in Fig. 4.

Herein, "paste coupling layer in which an electrical connection in a second insulating layer that is the second layer counted from the surface layer is a conductive paste" means paste coupling layers 116a and 116b in Fig. 4. Furthermore, the first insulating layer that is the first layer counted from the surface layer corresponds to film 102a in Fig. 4. The "second wiring provided in the second layer counted from the surface layer" corresponds to second wiring 106a in Fig. 4. Furthermore, the "third wiring provided in the third layer counted from the surface layer" corresponds to second wiring 106b formed on the double-sided board 114b and embedded in paste coupling layer 116b when the layers are counted from the upper part to the lower part in Fig. 4 (in the case of wirings, only wirings are counted).

### (FOURTH EXEMPLARY EMBODIMENT)

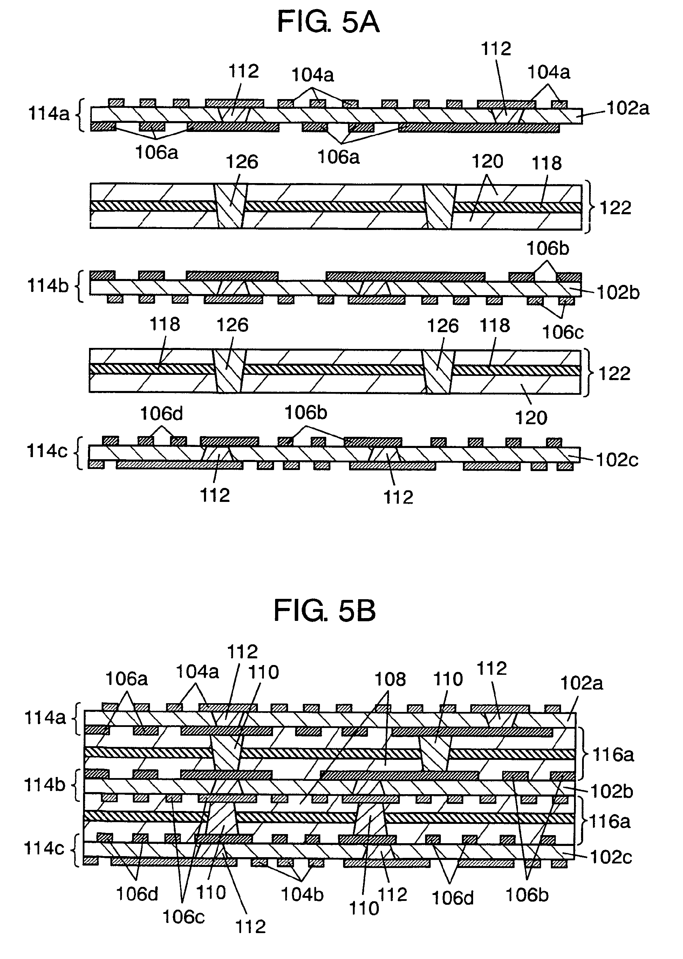

Hereinafter, a method of manufacturing a multilayer board in a fourth exemplary embodiment of the present invention is described with reference to drawings. Figs. 5A and 5B are sectional views to illustrate a method of manufacturing a multilayer printed wiring board in accordance with the fourth exemplary embodiment. The fourth exemplary embodiment shows an example of a method of manufacturing a multilayer by using a plurality of films, and shows for example, the method of manufacturing a multilayer board in accordance with the third exemplary embodiment.

Firstly, as shown in Fig. 5A, a plurality of film prepregs 122 having through holes filled with conductive pastes 126 are prepared. Similarly, double-sided boards 114a, 114b and 114c using resin films 102a, 102b and 102c are prepared. These are aligned with each other as shown in Fig. 5A.

Fig. 5B is a sectional view showing a state in which samples in Fig. 5A are integrated with each other. Specifically, Fig. 5B shows a product obtained by bonding the samples in a state shown in Fig. 5A by the use of, for example, a vacuum hot press so as to be hardened and integrated. At this pressing and laminating time, by heating the product at a predetermined temperature profile, provisionally hardened resin 120 is softened and hardened, and then changed into insulating resin 108. Conductive paste 126 embedded in film prepreg 122 is simultaneously heated and hardened, and then turns into IVH 110.

Furthermore, a method of manufacturing a multilayer board in accordance with the fourth exemplary embodiment is described in detail. Firstly, as provisionally hardened resin 120, film prepreg 122 obtained by applying epoxy resin on the surface of a polyimide film followed by provisionally hardening thereof is prepared. Then, as shown in Fig. 2B, through holes 124 are formed in predetermined positions in provisionally hardened resin 120 together with a protective film formed thereon. Next, on the protective film, a predetermined amount of conductive paste 126 is added. Conductive paste 126 is filled into through holes 124 formed in provisionally hardened resin 120 by using a squeegee (rubber spatula). Then, the protective film is peeled. As a result, film prepreg 122 is processed as shown in Fig. 5A.

Next, a double-sided copper-clad film is prepared. Specifically, a film obtained by attaching copper foil on both surfaces of a 10 µm-thick aramid film without using any adhesives is used. As such a film, commercially available CCL can be used. Next, the copper foil part of the double-sided copper-clad film is processed into a predetermined pattern so as to form double-sided boards 114a, 114b and 114c shown in Fig. 5A. As CCL, it is desirable to select CCL without using an adhesive. Thus, by selecting the double-sided copper-clad film without using an adhesive for bonding of a copper foil, for example, the double-sided copper-clad film by using a thin film method for a base material and the like, problems caused by an adhesive can be prevented.

As shown in Fig. 5A, film prepregs 122 filled with conductive pate 126 and double-sided boards 114a, 114b and 114c are alternately laminated and aligned. Thereafter, they are pressed for a predetermined time and at a predetermined temperature in a vacuum press so as to integrate them. At this time, if necessary, vacuum hot pressing may be employed. Furthermore, this pressing condition is made to be a condition in which provisionally hardened resin 120 is softened and then hardened. Thereby, a plurality of double-sided boards 114a, 114b and 114c can be integrated by using provisionally hardened resin 120a in a state in which the plurality of double-sided boards 114a, 114b and 114c are interposed. Furthermore, in the pressing condition, conductive paste 126 electrically couples second wiring 106a and second wiring 106b, which are formed at the side of film prepreg 122 of double-sided boards 114a, 114b and 114c.

Thus, a very thin multilayer board as shown in Fig. 5B can be produced. Herein, when the thicknesses of films 102a, 102b and 102c and provisionally hardened resin 120, for example, are reduced to, for example, the thickness of 40 µm or 20 µm, and furthermore 10 µm, a very thin multilayer board having a total thickness of about not more than 100 µm, or not more than 60 µm, furthermore not more than 30 µm can be produced.

### (FIFTH EXEMPLARY EMBODIMENT)

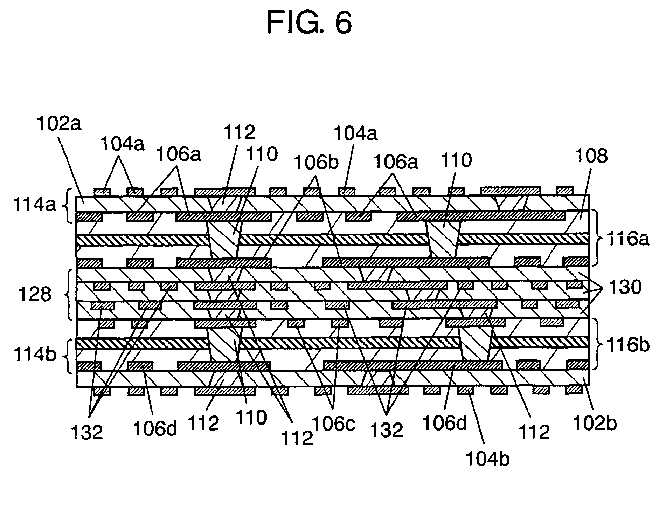

Hereinafter, a multilayer board in accordance with a fifth exemplary embodiment of the present invention is described. Fig. 6 is a sectional view showing a multilayer printed wiring board in accordance with the fifth exemplary embodiment. The fifth exemplary embodiment is different from the third exemplary embodiment in that the central part of the third exemplary embodiment is a two-layer board, but the central part of the fifth exemplary embodiment is a three-layer board. Thus by using the fifth exemplary embodiment, a variety of multilayer boards can be formed by using other than a double-sided board using a film and the like.

As shown in Fig. 6, a multilayer board in accordance with the fifth exemplary embodiment includes multilayer board 128, interlayer insulating layer 130 and inner electrode 132. Herein, multilayer board 128 includes a plurality of inner electrodes 132 that are interlayer-insulated by interlayer insulating layers 130, interlayer coupling part 112, and the like. On the surface thereof, second wirings 106b and 106c are exposed. As shown in Fig. 6, second wirings 106b and 106c that are wirings formed on the surface of multilayer board 128 are both embedded in paste coupling layers 116a and 116b. Similarly, on the surfaces of films 102a and 102b, first wirings 104a, 104b, second wirings 106a, and 106d are formed and both are electrically coupled to each other by interlayer coupling part 112. Thus, double-sided boards 114a and 114b are formed.

As shown in Fig. 6, second wiring 106a formed at the side of paste coupling layer 116a of double-sided board 114a and second wiring 106b formed at the side of paste coupling layer 116a of multilayer board 130 are both embedded in paste coupling layer 116a so as to be electrically coupled to each other with IVH 110. Similarly, second wiring 106d on double-sided board 114b and second wiring 106c on multilayer board 128 are coupled to each other with IVH 110 penetrating paste coupling layer 116b.

Thus, multilayer board 128 is disposed at the center and double-sided boards 114a and 114b are formed on both side or both surfaces of multilayer board 128. The wiring thicknesses can be absorbed by paste coupling layer 116, and they are integrated to each other. Thus, interlayer coupling can also be carried out. Furthermore, in the fifth exemplary embodiment, since paste coupling layers 116a and 116b including a hardened product of film prepreg 122 are used, even if a paste coupling layer is thinned, short-circuit between second wirings 106a and 106b, or between second wirings 106c and 106d can be prevented.

### (SIXTH EXEMPLARY EMBODIMENT)

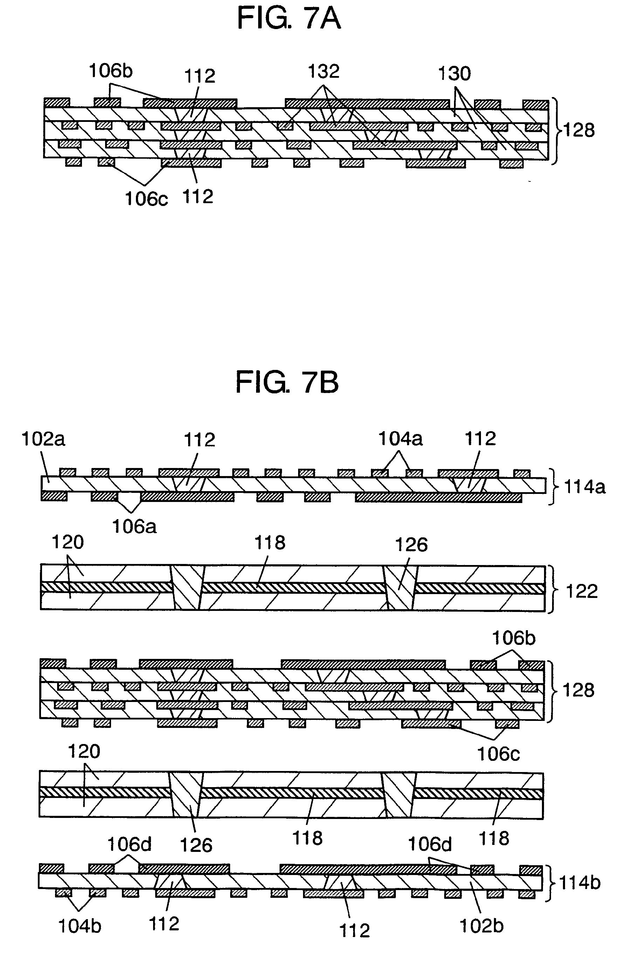

A method of manufacturing a multilayer board in a sixth exemplary embodiment is described in more detail with reference to Figs. 7A and 7B.

Figs. 7A and 7B are sectional views to illustrate a method of manufacturing a multilayer printed wiring board in accordance with the sixth exemplary embodiment, for example, a method of manufacturing the multilayer board of the fifth exemplary embodiment.

Firstly, as shown in Fig. 7A, multilayer board 128 is prepared. In multilayer board 128, inner electrodes 132 are sandwiched by interlayer insulating layers 130 and coupled to each other via interlayer coupling part 112. Furthermore, on the surface of multilayer board 128, second wirings 106b and 106c are exposed. As such multilayer board 128, a commercially available glass epoxy multilayer board can be used.

Fig. 7B is a sectional view showing a state in which double-sided board is set in the center and films are disposed at the both sides thereof. In Fig. 7B, film prepregs 122 filled with conductive paste 126 are set at both sides of multilayer board 128 so that conductive paste 126 is disposed in a predetermined position. Then, at the outside of film prepreg 122, double-sided boards 114a and 114b are set in a state in which they are aligned with each other. In this state, when they are heated and pressed by using, for example, a vacuum press, these members are integrated. Then, as shown in Fig. 6, a multilayer board is produced.

In particular, in the case of a multilayer board, the surface layer is often required to have a fine pattern. In such a case, a conventional multilayer board, for example, multilayer board 128 shown in Fig. 7A cannot sometimes meet the requirement. Then, as shown in Fig. 7B, by attaching double-sided boards 114a and 114b corresponding to a fine pattern on the necessary surface, a fine pattern can be realized. When lamination and integration of double-sided boards 114a and 114b by using film prepreg 122 are not necessarily on both surfaces. They may be carried out on only a necessary surface, for example, on only a single surface.

It is desirable that the hardening temperature of film prepreg 122 is in the range from 85°C to 220°C. The temperature of not less than 230°C may cause variation in hardening of resin and affect the dimension property. On the other hand, the temperature of lower than 85°C may increase the time for hardening the resin and affect the hardening state. Furthermore, in particular, when the thickness of the film constituting retention film 118 is thin, for example, not more than 50 µm, it is desirable that film prepreg 122 is hardened in the range from not less than 180°C and not more than 220°C. Thus, among the wirings formed on the surfaces of double-sided board 114a and 114b, second wirings 106a and 106d formed at the side of provisionally hardened resin 120 can be embedded in provisionally hardened resin 120 or in the thickness of provisionally hardened resin 120.

Furthermore, it is desirable that the range of pressure at the time of laminating film prepreg 122 is not less than 2 MPa (MPa stands for megapascal, that is, a unit for pressure) and not more than 6 MPa. The pressure of less than 2 MPa may cause variation of adhesiveness of the multilayer board shown in Fig. 7B. Furthermore, it is desirable that the time of applying pressure is not less than one minute and less than three hours. The time of applying pressure of less than one minute may cause variation in the pressure. Furthermore, the time of applying pressure of more than three hours may affect the productivity. Therefore, it is desirable that the pressure is 2 MPa or more and 6 MPa or less, and in particular 4 MPa or more and 6 MPa or less. In the case of general multilayer boards, lamination is carried out at the pressure in the range from 2 MPa to 3 MPa or less. However, in the method of manufacturing the multilayer printed wiring board in the sixth exemplary embodiment, since film 102 is thin and conductive paste 126 that is susceptible to the effect of the variation in thickness is used, it is desirable that the laminating pressure is about 5 MPa, for example, not less than 4 MPa and not more than 6 MPa, which is rather higher pressure.

The following is a further specific description. Firstly, as film prepreg 122, a long-length heat resistant resin film in which thermosetting resin is applied to a predetermined thickness on both surfaces thereof is produced. The thickness of application is not less than 5 microns and not more than 100 microns, desirably not less than 10 microns and not more than 50 microns, further preferably not less than 15 microns and not more than 30 microns. In the case where the resin thickness is less than 2 microns, only a thin electrode having a thickness of about 2 microns can be embedded in the resin. Therefore, it is desirable that the thickness of provisionally hardened resin 120 constituting film prepreg 122 is, for example, the same level or larger than the thickness of embedded wirings corresponding to second wirings 106a, 106b, 106c and 106d. Thus, second wirings 106a and 106b, and the like, can be embedded, and at the same time, the thickness can be absorbed.

### (SEVENTH EXEMPLARY EMBODIMENT)

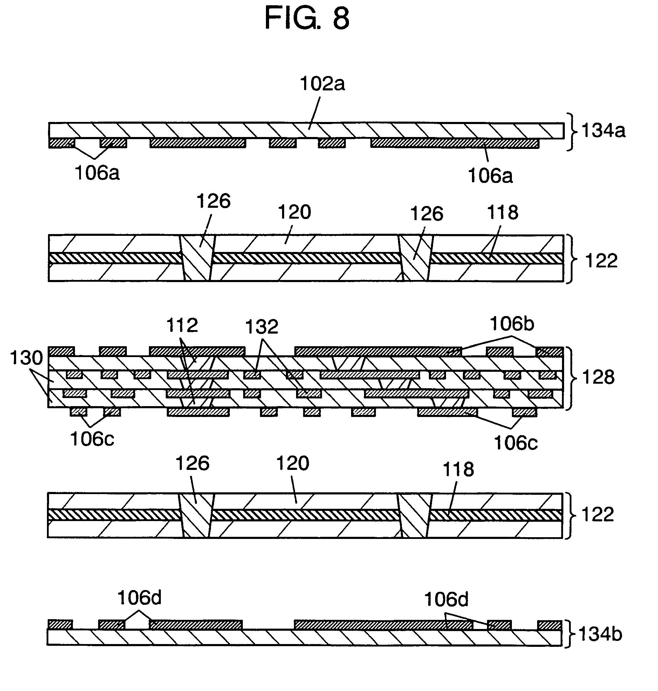

A seventh exemplary embodiment is described with reference to Figs. 8, 9A, 9B, 10A, and 10B. Figs. 8, 9A, 9B, 10A, and 10B are sectional views showing an example of a method of manufacturing a multilayer printed wiring board having a fine pattern on the surface layer thereof. In the seventh exemplary embodiment, the case in which a multilayer board having a surface layer made of a film is used and interlayer coupling and wirings of the surface layer are made to be finer by using a plating technique is described.

Fig. 8 is a sectional view to illustrate a method of manufacturing a multilayer board in accordance with the seventh exemplary embodiment. The seventh exemplary embodiment shows an example of the method of manufacturing a multilayer board described in the sixth exemplary embodiment and the method can be also applied to the first exemplary embodiment and the third exemplary embodiment. In particular, in the seventh exemplary embodiment, an electrode on the surface layer of the multilayer board, that is, an insulating material forming a first insulating layer that is the first layer counted from the surface layer is a resin film, the first wiring counted from the surface layer and an interlayer coupling part coupled to the wiring are integrated by using a plating technique. Thus, a high performance and fine a pattern can be achieved.

As shown in Fig. 8, single-sided board 134a includes resin film 102a and second wiring 106a formed on one surface of single-sided board 134a. Similarly, single-sided board 134b includes resin film 102b and second wiring 106d formed on one surface of single-sided board 134b. Furthermore, multilayer board 128 includes inner electrode 132, interlayer insulating layer 130 and interlayer coupling part 112. On the surface of multilayer board 128, second wirings 106b and 106c are formed.

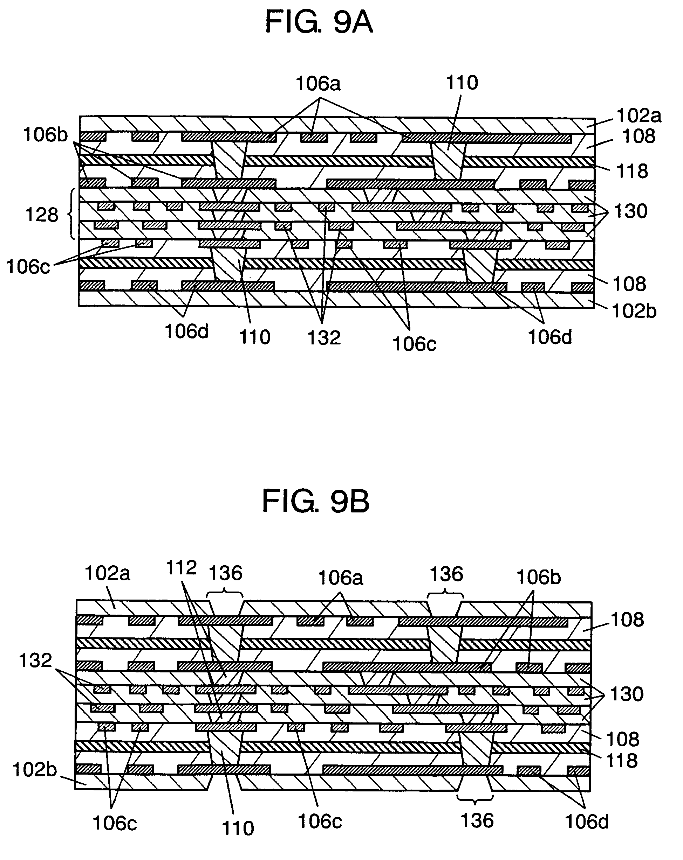

Furthermore, a hole penetrating film prepreg 122 is filled with conductive paste 126. Then, these members are aligned as shown in Fig. 8. Thereafter, by using a vacuum press and the like, as shown in Fig. 9A, heating and integration is carried out so as to form a multilayer board. Fig. 9A is a sectional view showing a state of the multilayer board after being integrated.

Fig. 9B is a sectional view showing a state in which the surface is provided with a blind via. As shown in Fig. 9B, blind via 136 is provided by forming a hole in resin films 102a and 102b that are the first layers counted from the surface layer by using, for example, a laser. Herein, by adjusting the laser power, its wavelength, pulse, and the like, as shown in Fig. 9B, second wirings 106a and 106d embedded in insulating resin 108 are exposed on the bottom of blind via 136.

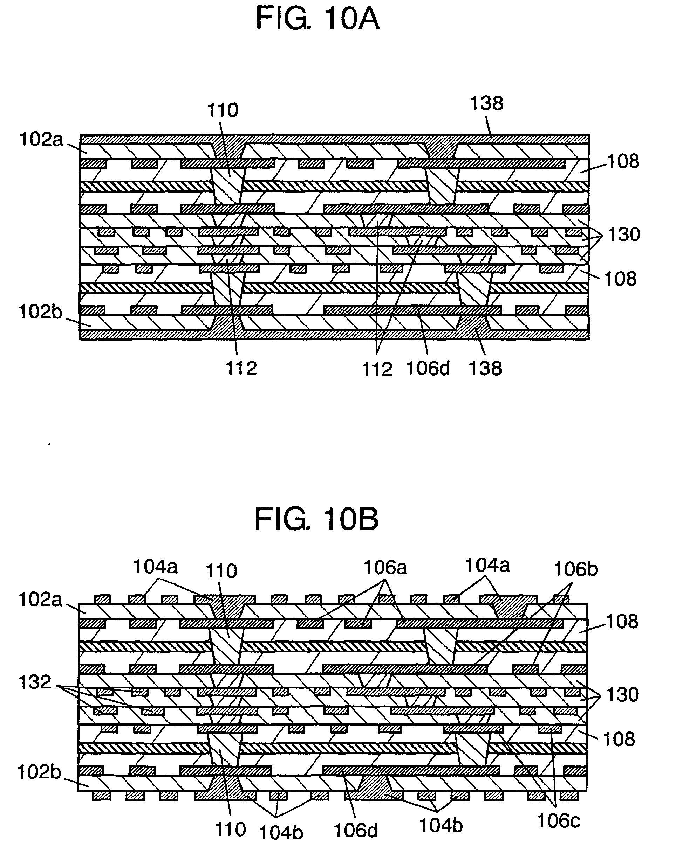

Next, with reference to Figs. 10A and 10B, a method of manufacturing a multilayer board in accordance with the seventh exemplary embodiment is described in detail. Fig. 10A is a sectional view showing a state in which the blind via is embedded in a metal film. Fig. 10A shows that blind via 136 and resin films 102a and 102b are covered with metal film 138. Next, as shown in Fig. 10B, metal film 138 is patterned in a predetermined shape. As shown in Fig. 10B, first wirings 104a and 104b that are the first wiring counted from the surface layer are formed by patterning metal film 138.

In order to form metal film 138, a plating method or a thin film method can be used. Furthermore, metal film 138 may be formed on both surfaces of the board as shown in Fig. 10A, or may be formed on only one surface if necessary. Furthermore, from Fig. 10A, metal film 138 formed so as to cover blind via 136 is electrically coupled to second wirings 106a and 106d formed at the side of insulating resin 108 of films 102a and 102b.

As shown in Fig. 10B, when metal film 138 is patterned into a predetermined shape, a part of metal film 138 covering blind via 136 is also remained as a via fill or via embedding material, so that first wirings 104a and 104b are formed. Then, first wirings 104a and 104b are electrically coupled to second wirings 106a and 106d via blind via 136.

Thus, as shown in Figs. 10A and 10B, by forming metal film 138 in blind via 136, first wiring 104 and second wiring 106 can be electrically coupled to each other via an electrical connection in the first insulating layer of the first layer counted from the surface layer, that is, blind via 136 formed in film 102. Therefore, interlayer coupling having a high reliability and low wiring resistance can be achieved.

### (EIGHTH EXEMPLARY EMBODIMENT)

In an eighth exemplary embodiment, a case in which the thin film method or the combination of the thin film method and the plating method is employed instead of the plating method is described. The eighth exemplary embodiment is different from the seventh exemplary embodiment in that the eighth exemplary embodiment uses the thin film method and the seventh exemplary embodiment uses the plating method. Since they are different from each other only in this point and they have many common points, this exemplary embodiment is described with reference to Fig. 9 used in the seventh exemplary embodiment.

Firstly, in order to form blind via 136 shown in Fig. 9B, a laser device of YAG and CO₂, and the like, can be used. Furthermore, in order to form metal film 138 on the surface of blind via 136, and the like, firstly, a base material layer (which is also referred to as "seed layer") is formed to the thickness of about 10Å to about 50Å by NiCr etc, and then copper may be electroplated thereon. Alternatively, copper may be electroless-plated on film 102 without using a seed layer. Alternatively, copper may be directly deposited on film 102 by using the thin film method using an electron beam, sputtering, and the like. In these cases, if a thickness is not less than 10Å and desirably, a thickness sufficient to obtain conductivity capable of being used for electroplating, the conductivity is used so as to form copper to the thickness necessary for wiring by electroplating. It is desirable that the thickness necessary for wiring is, for example, 5 µm to 30 µm, and 3 µm to 15 µm if thinning is required. In this way, by using a seed layer (or a metal base material) or by devising a method of forming a metal film, adhesive strength with respect to films 102a and 102b can be enhanced.

Thus, by fixing at least one of the first wiring formed in the first layer counted from the surface layer and the second wiring formed in the second layer counted from the surface layer to the first insulating layer that is the first layer counted from the surface layer via a sputtered film, the adhesiveness of metal film 138, first wiring 104 and second wiring 106, and the like, with respect to the surface of film 102 can be enhanced.

As mentioned above, a multilayer printed wiring board has three insulating layers. The second insulating layer (corresponding to paste coupling layer 116 in Fig. 1) that is the second layer counted from the surface layer is paste coupling layer 116 in which an electrical connection penetrating the second insulating layer is conductive paste 126 (or IVH 110 that is a hardened product thereof), and includes at least a second wiring (corresponding to second wiring 106a in Fig. 1) formed in the second layer counted from the surface layer and embedded in the paste coupling layer and a third wiring (corresponding to third wiring 106b in Fig. 1) formed in the third layer counted from the surface layer and embedded in the paste coupling layer. Thus, the multilayer printed wiring board can be thinned.

Furthermore, a multilayer printed wiring board has not less than four insulating layers. The second insulating layer (corresponding to paste coupling layer 116 in Fig. 1) that is the second layer counted from at least one of the surface layers is paste coupling layer 116 in which an electrical connection penetrating the second insulating layer is conductive paste 126 or IVH 110 that is a hardened product thereof. The second insulating layer includes paste coupling layer 116 in which an electrical connection penetrating paste coupling layer 116 is a conductive paste or IVH 110 that is a hardened product thereof is provided. The second wiring layer formed in the second layer (corresponding to second wiring 106a in Fig. 1) counted from at least one of the surface layers and the third wiring layer formed in the third layer (corresponding to second wiring 106a in Fig. 1) counted from at least one of the surface layers are embedded in the conductive paste coupling layer. Thus, the multilayer printed wiring board can be further thinned.

Furthermore, paste coupling layer 116 includes film prepreg 122 made of retention film 118 and provisionally hardened resin 120 that is a provisionally hardened thermosetting resin formed on both surfaces of retention film 118, and conductive paste 126 filled in through hole 124 formed in film prepreg 122. Thus, a multilayer board can be further thinned.

Furthermore, the surface layer includes a resin film. A first insulating layer that is the first layer counted from the surface layer including a resin film, for example, resin films 102a and 102b in Fig. 1, and a wiring formed on the surface of the first insulating layer without using an adhesive and, for example, by using the thin film method for a base material, for example, first wirings 104a and 104b or second wirings 106a and 106b in Fig. 1, and the like, are provided. Thereby, adhesive strength between the resin film and the wirings can be enhanced. At the same time, since an adhesive is not used for bonding, thinning can be achieved.

Furthermore, a first wiring formed in the first layer counted from the surface layer, for example, first wiring 104a in Fig. 1, and a second wiring formed in the second layer counted from the surface layer, for example, second wiring 106a in Fig. 1, are fixed to the first insulating layer that is the first layer counted from the surface layer, for example, resin film 102a in Fig. 1, via a sputtered film. Thus, coupling strength can be enhanced. It is possible to provide a multilayer printed wiring board that can be further thinned.

Furthermore, at least one of the first wiring formed in the first layer counted from the surface layer, for example, first wiring 104a in Fig. 1 and the second wiring formed in the second layer counted from the surface layer, for example, second wiring 106a in Fig. 1 is fixed to the first insulating layer that is the first layer counted from the surface layer, for example, resin film 102a in Fig. 1 via a plating film. Thus, coupling strength can be enhanced. It is possible to provide a multilayer printed wiring board that can be further thinned.

Furthermore, when interlayer coupling part 112 that is an electrical connection penetrating the first insulating layer formed in the first layer counted from the surface layer, for example, resin film 102a in Fig. 1 is made by plating, a multilayer board whose surface layer is made to have fine pattern can be thinned as shown in Figs. 8, 9A, 9B, 10A and 10B.

Furthermore, it is possible to thin a multilayer printed wiring board by carrying out a hole processing step of processing through hole 124 in film prepreg 122 that is an insulating base material; a paste coupling layer formation step of filling conductive paste 126 into through hole 122 so as to form paste coupling layer 116; a double-sided board formation step of forming double-sided board 114a shown in Fig. 3A; a laminating step of laminating double-sided boards 114a and 114b on the front and back surfaces of film prepreg 122 so as to form a laminated body by using film prepreg 122 as paste coupling layer 116; and a hot pressing step of hot pressing the laminated body in a vacuum press, and the like, and integrating the hot-pressed laminated body.

It is possible to produce a multilayer printed wiring board that can be thinned by carrying out at least a hole processing step of processing through hole 124 in an insulating base material including film prepreg 122; a paste coupling layer formation step of filling conductive paste 126 into through hole 124 so as to form paste coupling layer 116; multilayer printed wiring board formation step of forming multilayer printed wiring board 128 having not less than two layers as shown in Fig. 8; laminating step of laminating double-sided boards 114a and the like described in, for example, Fig. 3A on the front and back surfaces of the paste coupling layer obtained by adding conductive paste 126 to film prepreg 122 so as to form a laminated body; and further hot pressing step of hot pressing the laminated body by using a vacuum press, and the like, and integrating the hot-pressed laminated body.

Furthermore, wirings formed on the front and back surfaces of double-sided board 114a, and the like, are electrically coupled to each other by the method described in Figs. 9A, 9B to Figs. 10A and 10B. Thus, it is possible to thin a multilayer printed wiring board capable of realizing semiconductor bare chip mounting, and the like, and in which wirings formed on the outermost layer are made to have a fine pattern.

Furthermore, an electrical connection of wirings formed on the front and back surfaces of the double-sided board are formed by plating as described in Figs 9A, 9B to Figs. 10A and 10B. Thus, it is possible to thin a multilayer printed wiring board capable of realizing semiconductor bare chip mounting, and the like, and having a fine pattern of the wiring formed on the outermost layer.

If necessary, an electrical connection on the front and back surfaces of double-sided board 114a and the like can be made by using conductive paste 126 other than plating. In this case, needless to say, the process can be used in Figs. 2A, 2B, 2C and the like.

Furthermore, as shown in Fig. 10B, an interlayer coupling formation step of forming interlayer coupling for electrically coupling between the wirings on the front and back surfaces of double-sided board 114a, that is, between first wiring 104a and second wiring 106b is made after being pressed and integrated following the hot pressing step and in a state in which the dimension is stable as described with respect to Figs. 9A and 9B to Figs. 10A and 10B. Thus, dimension precision, handling, and the like, can be further improved.

Furthermore, as shown in Fig. 10B, since interlayer coupling formation step of double-sided board 114a includes at least a via processing step of forming blind via 136, it can be employed for, for example, semiconductor bare chip mounting and a multilayer printed wiring board having a fine patterned wiring on the outer surface layer can be thinned.

### INDUSTRIAL APPLICABILITY

As mentioned above, a multilayer board and method of manufacturing the same in the present invention can produce a very thin multilayer board that has not been achieved conventionally by combining a film and a multilayer board, and therefore, can be used for reducing the size and thickness of various electronic equipment and portable equipment.

## Claims

1. A multilayer printed wiring board including at least three insulating layers (102a, 102b, 116) comprising:
a second insulating layer (116) that is a second layer counted from a surface layer, which is a paste coupling layer (116) in which an electrical connection (110) penetrating the second insulating layer (116) is a conductive paste, and which includes a second wiring (106a) formed in a second layer counted from the surface layer and embedded in the paste coupling layer (116) and a third wiring (106b) formed in a third layer counted from the surface layer and embedded in the paste coupling layer (116);
a first insulating layer (1 02a) that is a first layer counted from the surface layer; and a wiring (104a) formed on the first insulating layer (102a);
**characterized in**
**that** the surface layer is formed of a heat-resistant resin film, and that the wiring is a copper wiring (104a) being formed on the first insulating layer (102a) via a seed layer formed as a base material by a thin film method.

2. A multilayer printed wiring board including at least three insulating layers (102a, 102b, 116) comprising:
a second insulating layer (116) that is a second layer counted from at least one of surface layers, which is a paste coupling layer (116) in which an electrical connection (110) penetrating the second insulating layer is a conductive paste, and which includes a second wiring (106a) formed in a second layer counted from the surface layer and embedded in the paste coupling layer (116) and a third wiring (106b) formed in a third layer counted from the surface layer and embedded in the paste coupling layer (116),
wherein at least one of a first wiring (104a) formed in a first layer counted from the surface layer and the second wiring (106a) formed in the second layer counted from the surface layer is fixed to a first insulating layer (1 02a) that is a first layer counted from the surface layer via a sputtered film;
**characterized in**
**that** the surface layer is formed of a heat-resistant resin film.

3. The multilayer printed wiring board according to claims 1 or 2, **characterized in that** it includes not less than four insulating layers, wherein the second insulating layer is the second layer counted from at least one of the surface layers.

4. The multilayer printed wiring board of any one of claims 1 to 3, **characterized in that** the paste coupling layer includes:
a film prepreg including a film and provisionally hardened thermosetting resin formed on both surfaces of the film; and
a conductive paste filled in a through hole formed in the film prepreg.

5. The multilayer printed wiring board of any one of claims 1 to 3, **characterized in that** at least one of the first wiring formed in the first layer counted from the surface layer and the second wiring formed in the second layer counted from the surface layer is fixed to the first insulating layer of the first layer counted from the surface layer via a plating film.

6. The multilayer printed wiring board of any one of claims 1 to 3, **characterized in that** an electrical connection penetrating the first insulating layer formed in the first layer counted from the surface layer is made by plating.

7. A method of manufacturing a multilayer printed wiring board, the method comprising: processing a through hole (126) in an insulating material (120);
forming a paste coupling layer (122) by filling the through hole (126) with a conductive paste;
forming a double-sided board (134a; 134b) or a multilayer printed wiring board having not less than two layers;
laminating double-sided boards (134a; 134b) on front and back surfaces of the paste coupling layer (122) so as to form a laminated body; and
hot pressing the laminated body;
**characterized in**
**that** the method further comprises a step of forming interlayer coupling (138) for electrically coupling the wirings (1 06a; 106d) on the front and back surfaces of the double-sided board (134a; 134b) after the hot pressing.

8. The method of manufacturing a multilayer printed wiring board according to claim 7, **characterized in that** wirings formed on the front and back surfaces of the double-sided board are electrically coupled to each other.

9. The method of manufacturing a multilayer printed wiring board according to claim 7 or 8, **characterized in that** an electrical connection between the wirings formed on the front and back surfaces of the double-sided board is made by plating.

10. The method of manufacturing a multilayer printed wiring board according to any one of claims 7 to 9, **characterized in that** an electrical connection between the front and back surfaces of the double-sided board is made by a conductive paste.

11. The method of manufacturing a multilayer printed wiring board according to any one of claims 7 to 10, **characterized in that** the forming of interlayer coupling for electrically coupling the wirings on the front and back surfaces of the double-sided board includes at least forming a blind via, and plating the blind via.

## Patentansprüche

1. Mehrschichtige Leiterplatte, die wenigstens drei isolierende Schichten (102a, 102b, 116) enthält, die umfassen:
eine zweite isolierende Schicht (116), die eine, von einer Oberflächenschicht aus gezählt, zweite Schicht ist und eine Pasten-Verbindungsschicht (116) ist, in der eine elektrische Verbindung (110), die in die zweite isolierende Schicht (116) eindringt, eine leitende Paste ist, und die eine zweite Verdrahtung (106a), die, in einer, von der Oberflächenschicht aus gezählt, zweiten Schicht ausgebildet und in der Pasten-Verbindungsschicht (116) eingebettet ist, sowie eine dritte Verdrahtung (106b) enthält, die in einer, von der Oberflächenschicht aus gezählt, dritten Schicht ausgebildet und in der Pastenverbindungsschicht (116) eingebettet ist;
eine erste isolierende Schicht (102a), die eine, von der Oberflächenschicht aus gezählt, erste Schicht ist; und
eine Verdrahtung (104a), die auf der ersten Isolierschicht (102a) ausgebildet ist;
**dadurch gekennzeichnet, dass**
die Oberflächenschicht aus einem wärmebeständigen Harzfilm besteht, und die Verdrahtung eine Kupferverdrahtung (104a) ist, die auf der ersten isolierenden Schicht (102a) über eine Keimschicht ausgebildet wird, die mit einem Dünnschichtverfahren als ein Trägermaterial ausgebildet wird.

2. Mehrschichtige Leiterplatte, die wenigstens drei isolierende Schichten (102a, 102b, 116) enthält, die umfassen:
eine zweite isolierende Schicht (116), die eine, von wenigstens einer der Oberflächenschichten aus gezählt, zweite Schicht ist und eine Pasten-Verbindungsschicht (116)
ist, in der eine elektrische Verbindung (110), die in die zweite isolierende Schicht eindringt, eine leitende Paste ist, und die eine zweite Verdrahtung (106a), die in einer, von der Oberflächenschicht aus gezählt, zweiten Schicht ausgebildet ist und in der Pasten-Verbindungsschicht (116) eingebettet ist, sowie eine dritte Verdrahtung (106b) enthält,
die in einer, von der Oberflächenschicht aus gezählt, dritten Schicht ausgebildet ist und in der Pasten-Verbindungsschicht (116) eingebettet ist,
wobei wenigstens eine erste Verdrahtung (104a), die in einer, von der Oberflächenschicht aus gezählt, ersten Schicht ausgebildet ist, oder die zweite Verdrahtung (106a), die in der, von der Oberflächenschicht aus gezählt, zweiten Schicht ausgebildet ist, an einer ersten isolierenden Schicht (102a), die eine, von der Oberflächenschicht aus gezählt, erste Schicht ist, über einen gesputterten Film fixiert ist;
**dadurch gekennzeichnet, dass**
die Oberflächenschicht aus einem wärmebeständigen Harzfilm besteht.

3. Mehrschichtige Leiterplatte nach Anspruch 1 oder 2, **dadurch gekennzeichnet, dass** sie nicht weniger als vier isolierende Schichten enthält, wobei die zweite isolierende Schicht die, von wenigstens einer der Oberflächenschichten aus gezählt, zweite Schicht ist.

4. Mehrschichtige Leiterplatte nach einem der Ansprüche 1 bis 3, **dadurch gekennzeichnet, dass** die Pasten-Verbindungsschicht enthält:
ein Film-Prepreg, das einen Film und ein vorläufig ausgehärtetes wärmehärtendes Harz enthält, das auf beiden Oberflächen des Films ausgebildet ist; und
eine leitende Paste, die in ein Durchgangsloch eingefüllt ist, das in dem Film-Prepreg ausgebildet ist.

5. Mehrschichtige Leiterplatte nach einem der Ansprüche 1 bis 3, **dadurch gekennzeichnet, dass** wenigstens die erste Verdrahtung, die in der, von der Oberflächenschicht aus gezählt, ersten Schicht ausgebildet ist, oder die zweite Verdrahtung, die in der, von der Oberflächenschicht aus gezählten, zweiten Schicht ausgebildet ist, über einen Plattierfilm an der ersten isolierenden Schicht der, von der Oberflächenschicht aus gezählt, ersten Schicht befestigt ist.

6. Mehrschichtige Leiterplatte nach einem der Ansprüche 1 bis 3, **dadurch gekennzeichnet, dass** eine elektrische Verbindung, die in die erste isolierende Schicht eindringt, die in der, von der Oberflächenschicht aus gezählt, ersten Schicht ausgebildet ist, durch Plattieren hergestellt wird.

7. Verfahren zum Herstellen einer mehrschichtigen Leiterplatte, wobei das Verfahren umfasst:
Schaffen eines Durchgangslochs (126) in einem isolierenden Material (120);
Ausbilden einer Pasten-Verbindungsschicht (122) durch Ausfüllen des Durchgangslochs (126) mit einer leitenden Paste;
Ausbilden einer doppelseitigen Platte (134a; 134b) oder einer mehrschichtigen Leiterplatte mit nicht weniger als zwei Schichten;
Laminieren doppelseitiger Platten (134a; 134b) an einer Vorder- und einer Rückseite der Pasten-Verbindungsschicht (122), um einen laminierten Körper auszubilden; und Heißpressen des laminierten Körpers;
**dadurch gekennzeichnet, dass**
das Verfahren des Weiteren einen Schritt des Ausbildens einer Zwischenschichtverbindung (138) zum elektrischen Verbinden der Verdrahtungen (106a; 106b) an der Vorder- und der Rückseite der doppelseitigen Leiterplatte (134a; 134b) nach dem Heißpressen umfasst.

8. Verfahren zum Herstellen einer mehrschichtigen Leiterplatte nach Anspruch 7, **dadurch gekennzeichnet, dass** Verdrahtungen, die an der Vorder- und der Rückseite der zweiseitigen Platte ausgebildet sind, elektrisch miteinander gekoppelt sind.

9. Verfahren zum Herstellen einer mehrschichtigen Leiterplatte nach Anspruch 7 oder 8, **dadurch gekennzeichnet, dass** eine elektrische Verbindung zwischen den auf der Vorder- und der Rückseite der doppelseitigen Platte ausgebildeten Verdrahtungen durch Plattieren hergestellt wird.

10. Verfahren zum Herstellen einer mehrschichtigen Leiterplatte nach einem der Ansprüche 7 bis 9, **dadurch gekennzeichnet, dass** eine elektrische Verbindung zwischen der Vorder- und der Rückseite der doppelseitigen Platte mit einer leitenden Paste hergestellt wird.

11. Verfahren zum Herstellen einer mehrschichtigen Leiterplatte nach einem der Ansprüche 7 bis 10, **dadurch gekennzeichnet, dass** das Ausbilden einer Zwischenschichtverbindung zum elektrischen Verbinden der Verdrahtungen an der Vorder- und der Rückseite der doppelseitigen Platte wenigstens Ausbilden einer Grund-Durchkontaktierung und Plattieren der Grund-Durchkontaktierung einschließt.

## Revendications

1. Carte de circuit imprimé multicouche comportant au moins trois couches isolantes (102a, 102b, 116) comprenant
une deuxième couche isolante (116) qui est une deuxième couche comptée à partir d'une couche de surface, qui est une couche (116) de couplage par pâte où une connexion électrique (110) pénétrant la deuxième couche isolante (116) est une pâte conductrice, et qui comporte un deuxième câblage (106a) formé dans une deuxième couche comptée à partir de la couche de surface et incorporée dans la couche (116) de couplage par pâte et un troisième câblage (106b) formé dans une troisième couche comptée à partir de la couche de surface et incorporée dans la couche (116) de couplage par pâte;
une première couche isolante (102a) qui est une première couche comptée à partir de la couche de surface; et un câblage (104a) formé sur la première couche isolante (102a);
**caractérisée en ce que**
la couche de surface est formée d'un film de résine résistant à la chaleur, et
**en ce que** le câblage est un câblage (104a) en cuivre qui est formé sur la première couche isolante (102a) à travers une couche germe formée en tant que matériau de base par un procédé de film mince.

2. Carte de circuit imprimé multicouche comportant au moins trois couches isolantes (102a, 102b, 116) comprenant:
une deuxième couche isolante (116) qui est une deuxième couche comptée à partir d'au moins l'une des couches de surface, qui est une couche (116) de couplage par pâte où une connexion électrique (110) pénétrant la deuxième couche isolante est une pâte conductrice, et qui comporte un deuxième câblage (106a) formé dans une deuxième couche comptée à partir de la couche de surface et incorporée dans la couche (116) de couplage par pâte et un troisième câblage (106b) formé dans une troisième couche comptée à partir de la couche de surface et incorporée dans la couche (116) de couplage par pâte,
où au moins l'un d'un premier câblage (104a) formé dans une première couche comptée à partir de la couche de surface et le deuxième câblage (106a) formé dans la deuxième couche comptée à partir de la couche de surface est fixé à une première couche isolante (102a) qui est une première couche comptée à partir de la couche de surface à travers un film pulvérisé;
**caractérisé en ce que**
la couche de surface est formée d'un film de résine résistant à la chaleur.

3. Carte de circuit imprimé multicouche selon les revendications 1 ou 2, **caractérisée en ce qu'**elle comporte pas moins de quatre couches isolantes, où la deuxième couche isolante est la deuxième couche comptée à partir d'au moins l'une des couches de surface.

4. Carte de circuit imprimé multicouche de l'une quelconque des revendications 1 à 3, **caractérisée en ce que** la couche de couplage par pâte comporte:
un pré-imprégné de film comportant un film et une résine thermodurcissable durcie provisoirement formée sur les deux surfaces du film; et
une pâte conductrice remplie dans un trou traversant formé dans le pré-imprégné de film.

5. Carte de circuit imprimé multicouche de l'une quelconque des revendications 1 à 3, **caractérisée en ce qu'**au moins le premier câblage formé dans la première couche comptée à partir de la couche de surface et le deuxième câblage formé dans la deuxième couche comptée à partir de la couche de surface est fixé à la première couche isolante de la première couche comptée à partir de la couche surface à travers un film de placage.

6. Carte de circuit imprimé multicouche de l'une quelconque des revendications 1 à 3, **caractérisée en ce qu'**une connexion électrique pénétrant la première couche isolante formée dans la première couche comptée à partir de la couche de surface est faite par placage.

7. Procédé pour fabriquer une carte de circuit imprimé multicouche, le procédé comprenant le fait de:
traiter un trou traversant (126) dans un matériau isolant (120);
former une couche (122) de couplage par pâte en remplissant le trou traversant (126) avec une pâte conductrice;
former une carte double face (134a, 134b) ou une carte de circuit imprimé multicouche ayant pas moins de deux couches;
stratifier des cartes double face (134a, 134b) sur des surfaces avant et arrière de la couche (122) de couplage par pâte de manière à former un corps stratifié; et
presser à chaud le corps stratifié;
**caractérisé en ce que**
le procédé comprend en plus une étape consistant à former un couplage (138) entre-couches pour coupler électriquement les câblages (106a, 106d) sur les surfaces avant et arrière de la carte double face (134a, 134b) après le pressage à chaud.

8. Procédé pour fabriquer une carte de circuit imprimé multicouche selon la revendication 7, **caractérisé en ce que** les câblages formés sur les surfaces avant et arrière de la carte double face sont accouplés électriquement les uns aux autres.

9. Procédé pour fabriquer une carte de circuit imprimé multicouche selon la revendication 7 ou 8, **caractérisé en ce qu'**une connexion électrique entre les câblages formés sur les surfaces avant et arrière de la carte double face est faite par placage.

10. Procédé pour fabriquer une carte de circuit imprimé multicouche selon l'une quelconque des revendications 7 à 9, **caractérisé en ce qu'**une connexion électrique entre les surfaces avant et arrière de la carte double face est réalisée grâce à une pâte conductrice.

11. Procédé pour fabriquer une carte de circuit imprimé multicouche selon l'une quelconque des revendications 7 à 10, **caractérisé en ce que** la formation d'un couplage entre-couches pour accoupler électriquement les câblages sur les surfaces avant et arrière de la carte double face comporte au moins la formation d'un trou de liaison borgne, et le placage du trou de liaison borgne.
